# EUROPEAN PATENT APPLICATION

(11) **EP 3 508 618 A1**
(43) Date of publication of application: **10.07.2019**
(21) Application number: 17846045.7
(22) Date of filing: 07.08.2017
(51) Int. Cl.: C25D 1/08, C25D 1/10

(54) **MESH FILTER PRODUCTION METHOD AND MESH FILTER**

(30) Priority: 01.09.2016 JP 2016170618
(71) Applicant: THINK LABORATORY CO., LTD., Kashiwa-shi, Chiba 277-8525 (JP)
(72) Inventor: SHIGETA, Tatsuo, Kashiwa-shi Chiba 277-8525 (JP)
(74) Representative: Mincone, Antimo
(86) International application number: PCT/JP2017/028511
(87) International publication number: WO 2018/043036

(57) **Abstract**

Provided are a method of producing a mesh filter, which is capable of forming more minute holes than by punching processing, and which makes it possible, by forming meshes of different openings on the same base material, to appropriately change a flow rate or a light amount with the various opening sizes, and a mesh filter.

The method of producing a mesh filter includes a step of producing a mesh filter by continuously plating a platable metal using a roll with a DLC pattern, wherein a mesh filter-shaped resist pattern is obtained by forming multiple mesh filter-shaped resist patterns of different openings on the same cylindrical metal base material.

## Description

### Technical Field

The present invention relates to a method of producing a mesh filter made of a metal, produced by continuously plating using a roll with a DLC pattern, which has a DLC pattern formed on a surface thereof, and to a mesh filter.

### Background Art

A mesh filter made of a metal has hitherto been known. The mesh filter made of a metal is used for applications of, for example, filtration.

Examples of such mesh filter made of a metal include: a mesh filter obtained by forming a metal wire into a mesh shape; and a mesh filter obtained by perforating a plate-shaped metal base material through punching processing.

In a related-art mesh filter produced by subjecting a metal base material to punching processing, it has been difficult to form micro holes on the order of micrometers. In addition, in a related-art mesh filter produced by using perforated metal, only meshes of the same opening can be formed on the same base material. Therefore, in order to change a flow rate, various mesh filters of different openings need to be prepared.

### Prior Art Document

### Patent Document

Patent Document 1: JP Hei 09-131506 A

### Summary of the Invention

### Problems to be solved by the Invention

An object of the present invention is to provide a method of producing a mesh filter, which is capable of forming more minute holes than by punching processing, and which makes it possible, by forming meshes of different openings on the same base material, to appropriately change a flow rate or a light amount with the various opening sizes, and a mesh filter.

### Means for Solving Problems

In order to solve the above-mentioned problems, a method of producing a mesh filter according to the present invention includes the steps of: preparing a cylindrical platable metal base material; forming a mesh filter-shaped resist pattern by applying a photoresist onto a surface of the cylindrical metal base material, exposure and development; forming a DLC coating film on surfaces of the cylindrical metal base material and the mesh filter-shaped resist pattern; forming a DLC pattern on the surface of the cylindrical metal base material by peeling off the DLC coating film formed on the mesh filter-shaped resist pattern together with the mesh filter-shaped resist pattern, thereby producing a roll with the DLC pattern; and producing a mesh filter by continuously plating a platable metal using the roll with the DLC pattern, wherein the mesh filter-shaped resist pattern is obtained by forming multiple mesh filter-shaped resist patterns of different openings on the same cylindrical metal base material.

It is preferred that the metal base material, onto which the photoresist is to be applied, be formed of at least one kind of material selected from the group consisting of nickel, tungsten, chromium, titanium, gold, silver, platinum, stainless steel, iron, copper, and aluminum.

It is preferred that the DLC coating film have a thickness of from 0.1 µm to 20 µm.

It is preferred that the multiple mesh filter-shaped resist patterns of different openings are a stepless gradation pattern in which sizes of the openings change in a stepless manner.

A mesh filter according to the present invention is produced by continuously plating a platable metal using a roll with a DLC pattern, wherein the roll with the DLC pattern is produced by: forming a mesh filter-shaped resist pattern by applying a photoresist onto a surface of a cylindrical platable metal base material, exposure and development; forming a DLC coating film on surfaces of the cylindrical metal base material and the mesh filter-shaped resist pattern; and forming a DLC pattern on the surface of the cylindrical metal base material by peeling off the DLC coating film formed on the mesh filter-shaped resist pattern together with the mesh filter-shaped resist pattern, wherein the mesh filter-shaped resist pattern is obtained by forming multiple mesh filter-shaped resist patterns of different openings on the same cylindrical metal base material, and wherein the mesh filter includes a plurality of mesh filter zones of different openings.

It is preferred that the metal base material, onto which the photoresist is to be applied, be formed of at least one kind of material selected from the group consisting of nickel, tungsten, chromium, titanium, gold, silver, platinum, stainless steel, iron, copper, and aluminum.

It is preferred that the DLC coating film have a thickness of from 0.1 µm to 20 µm.

It is preferred that the multiple mesh filter-shaped resist pattern of different openings are a stepless gradation pattern in which sizes of the openings change in a stepless manner.

A fluid flow rate control mechanism according to the present invention includes: the mesh filter including a plurality of mesh filter zones of different openings; and a slide mechanism configured to slide the mesh filter, and the fluid flow rate control mechanism is capable of controlling a flow rate of a fluid through a mesh filter zone of an arbitrary opening by sliding the mesh filter.

A light amount control mechanism according to the present invention includes: the mesh filter including a plurality of mesh filter zones of different openings; and a slide mechanism configured to slide the mesh filter, and the light amount control mechanism is capable of controlling a light amount through a mesh filter zone of an arbitrary opening by sliding the mesh filter.

### Advantageous Effects of the Invention

The present invention has great effects of being capable of providing the method of producing a mesh filter, which is capable of forming more minute holes than by punching processing, and which makes it possible, by forming meshes of different openings on the same base material, to appropriately change a flow rate or a light amount, and the mesh filter.

In the mesh filter according to the present invention, a plurality of different meshes, for example, in opening sizes from 10 µm to 500 µm, can be formed on the same base material. Therefore, by sliding such mesh filter, the mesh filter is possible to appropriately change the opening sizes. Such mesh filter capable of appropriately changing the openings can be used for various applications. As such applications, for example, the mesh filter can be used as a mesh filter for controlling a flow rate of a fluid, such as a gas or a liquid, or controlling a light amount.

### Brief Description of Drawings

FIG. 1 is a schematic view for illustrating an embodiment in which a mesh filter according to the present invention is provided with a slide mechanism.
FIG. 2 is a schematic view for illustrating an embodiment of a roll with a DLC pattern to be used for a method of producing a mesh filter according to the present invention.

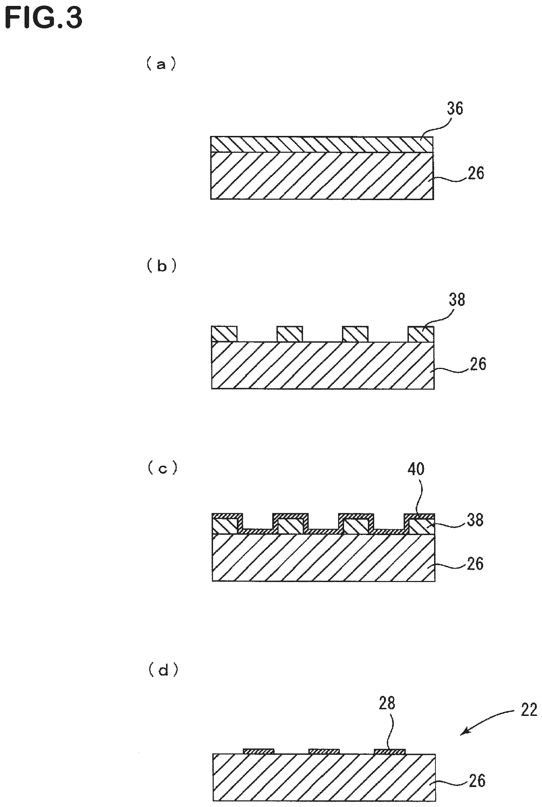

FIG. 3 is explanatory view for schematically illustrating an example of a method of producing the roll with the DLC pattern to be used for the method of producing a mesh filter according to the present invention. In FIG. 3, (a) is a sectional view of a main portion in a state in which a photoresist is applied onto a surface of a cylindrical metal base material, (b) is a sectional view of the main portion in a state in which a mesh filter-shaped resist pattern is formed through exposure and development, (c) is a sectional view of the main portion in a state in which a DLC coating film is formed on surfaces of the cylindrical metal base material and the mesh filter-shaped resist pattern, and (d) is a sectional view of the main portion in a state in which the DLC coating film formed on the mesh filter-shaped resist pattern is peeled off together with the mesh filter-shaped resist pattern.
FIG. 4 is a flowchart for illustrating the order of steps of the method of producing the roll with the DLC pattern illustrated in FIGS. 3.
FIG. 5 is a photograph of a mesh filter produced in Example 1.

### Description of Embodiments

Embodiments of the present invention are described below, but these embodiments are described as examples, and hence it is understood that various modifications may be made thereto without departing from the technical spirit of the present invention.

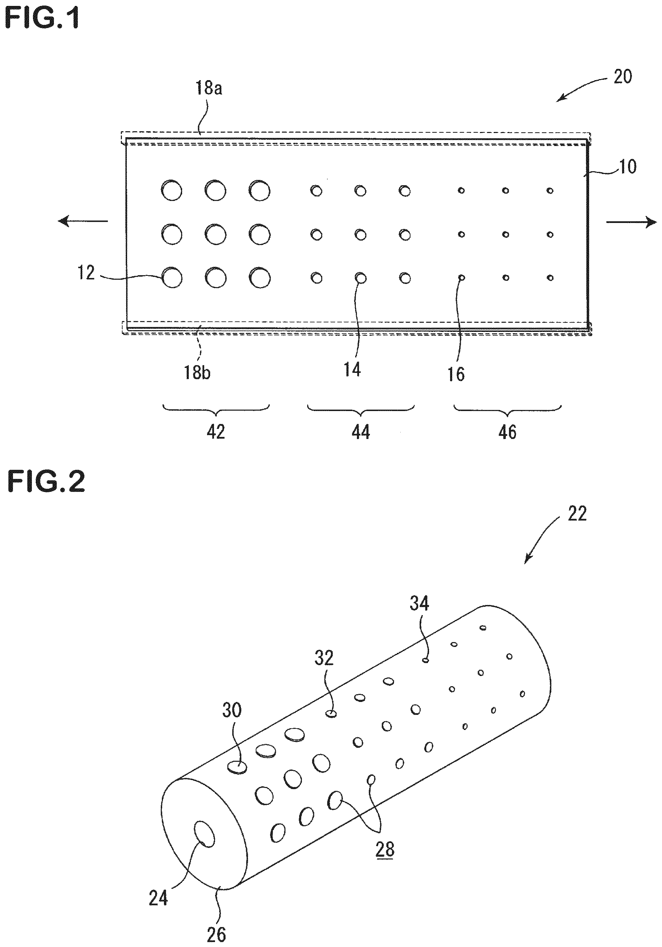

In FIG. 1, a mesh filter according to the present invention is denoted by reference numeral 10. A mesh filter 10 is a filter produced through plating, and hence is made of a metal.

The mesh filter 10 is perforated with many holes having different opening sizes. The mesh filter according to the present invention has a mesh shape of, for example, a net shape or a hole shape.

In an example illustrated in FIG. 1, the mesh filter 10 is perforated with a plurality of holes 12, 14, and 16 having opening sizes different from one another. The plurality of holes 12, 14, and 16 form mesh filter zones 42, 44, and 46, respectively. The holes 12 each have a diameter of, for example, 100 µm, the holes 14 each have a diameter of, for example, 50 µm, and the holes 16 each have a diameter of, for example, 10 µm.

In the example illustrated in FIG. 1, the mesh filter 10 is provided with slide mechanisms 18a and 18b arranged on upper and lower sides thereof, and serves as a fluid flow rate or light amount control mechanism 20.

The slide mechanisms 18a and 18b are each a rail, and the mesh filter 10 in a plate shape is sandwiched therebetween. With this, when slid laterally, the mesh filter 10 can be appropriately changed in hole size, for example, from the holes 12 each having a diameter of 100 µm to the holes 14 each having a diameter of 50 µm, and further to the holes 16 each having a diameter of 10 µm.

In FIG. 2, a roll with DLC patterns is denoted by reference numeral 22. A roll 22 with DLC patterns includes: a cylindrical metal base material 26 having a through hole 24 at a center thereof; and DLC patterns 28 formed on the surface of the cylindrical metal base material 26. In an example illustrated in FIG. 2, circular protrusions 30 each having a diameter of, for example, 100 µm, circular protrusions 32 each having a diameter of, for example, 50 µm, and circular protrusions 34 each having a diameter of, for example, 10 µm are formed as the DLC patterns 28.

Any platable metal can be applied to the cylindrical metal base material 26, but for example, the cylindrical metal base material 26 may be formed of at least one kind of material selected from the group consisting of nickel, tungsten, chromium, titanium, gold, silver, platinum, stainless steel, iron, copper, and aluminum.

In addition, it is also appropriate to adopt a configuration in which the cylindrical metal base material 26 is formed on a carbon fiber reinforced plastics (CFRP) material, or formed on a cushion layer formed of a rubber or a resin having a cushioning property.

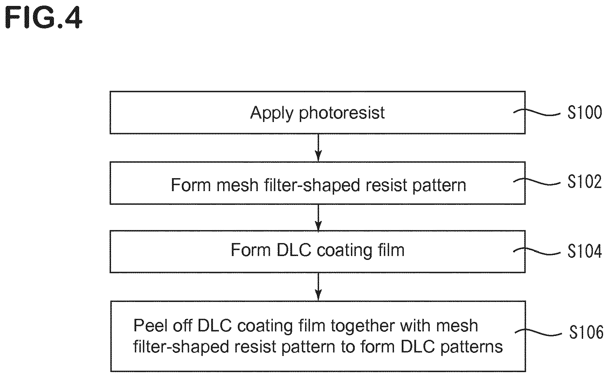

A method of producing the roll 22 with DLC patterns is described with reference to FIG. 3 and FIG. 4. First, the cylindrical metal base material 26 is prepared, a photoresist 36 is applied onto the surface of the cylindrical metal base material 26 as illustrated in FIG. 3(a) (Step 100 of FIG. 4), and the photoresist 36 is exposed and developed to form a mesh filter-shaped resist pattern 38 on the surface of the cylindrical metal base material 26 (Step 102 of FIG. 4). The photoresist 36 is preferably a negative photoresist. With this, a state illustrated in FIG. 3(b) is achieved.

Moreover, a DLC coating film 40 is formed on the surfaces of the cylindrical metal base material 26 and the mesh filter-shaped resist pattern 38 (Step 104 of FIG. 4). With this, a state illustrated in FIG. 3(c) is achieved.

Next, the DLC coating film 40 formed on the mesh filter-shaped resist pattern 38 is peeled off together with the mesh filter-shaped resist pattern 38 to form the DLC patterns 28 on the surface of the cylindrical metal base material 26. Thus, the roll 22 with DLC patterns is produced (Step 106 of FIG. 4). With this, a state illustrated in FIG. 3(d) is achieved.

Moreover, the mesh filter 10 as illustrated in FIG. 1 is obtained by continuously plating a platable metal by using the roll 22 with DLC patterns. As the platable metal plated by using the roll 22 with DLC patterns, any platable metal can be applied, and for example, nickel, tungsten, chromium, titanium, gold, silver, platinum, iron, copper, and aluminum can be applied. For example, when the cylindrical metal base material 26 is formed of copper, nickel can be applied as the metal for plating with the roll 22 with DLC patterns.

In forming the DLC coating film 40, the surfaces of the cylindrical metal base material 26 and the mesh filter-shaped resist pattern 38 may be coated with DLC by a chemical vapor deposition (CVD) method or a sputtering method.

The DLC coating film 40 preferably has a thickness of from 0.1 µm to 20 µm. More specifically, the DLC coating film 40 more preferably has a thickness of from 0.1 µm to 5 µm.

A plurality of mesh filter-shaped resist pattern having the different openings is preferably a stepless gradation pattern in which the openings change in a stepless manner. The "stepless gradation pattern" means a stepless gradation pattern in which discontinuities in "stepwise changes" are hardly recognized.

The DLC coating film formed on the mesh filter-shaped resist pattern serving as the stepless gradation pattern is peeled off together with the mesh filter-shaped resist pattern to form the DLC patterns on the surface of the cylindrical metal base material, to thereby produce the roll with DLC patterns. By continuously plating the platable metal using the roll with DLC patterns, a mesh filter including a plurality of stepless gradational mesh filter zones having different opening in which a stepwise change in opening size is hardly recognized, is obtained. Such mesh filter with optionally variable openings serves as a stepless variable mesh filter capable of controlling a flow rate of a fluid or a light amount in a stepless manner.

### Examples

Now, the present invention is more specifically described by way of Examples, but it is needless to say that Examples are only illustrative and should not be interpreted as limiting the present invention.

### (Example 1)

A plate base material (aluminum hollow roll) having a circumference of 600 mm and a surface length of 1,100 mm was prepared, and a roll with DLC patterns described below was produced therefrom with a device of New FX series (fully automated laser gravure cylinder making system manufactured by Think Laboratory Co., Ltd.).

First, the plate base material (aluminum hollow roll) was mounted to a copper plating bath. The hollow roll was fully immersed in a plating solution, and a copper-plated layer having a thickness of 80 µm was formed thereon at a current density of 30 A/dm² and a voltage of 6.0 V. No nodules and pits were generated on a plating surface, and a uniform copper-plated layer was obtained.

The surface of the copper-plated layer was polished with a double head polishing machine (polishing machine manufactured by Think Laboratory Co., Ltd.) and served as a uniform polished surface. The copper-plated layer having been formed was used as a base material, and a photosensitive film (resist for semiconductor laser: TSER-NS (manufactured by Think Laboratory Co., Ltd.)) was applied onto a surface thereof with a fountain coater, followed by drying. The film thickness of the resultant photosensitive film was measured with a film thickness meter (F20 manufactured by Filmetrics Inc.), and as a result, was found to be 15 µm. Next, an image was developed through laser exposure. The laser exposure was performed by exposing the photosensitive film to a predetermined pattern under an exposure condition of 300 mJ/cm² with Laser Stream FX. In addition, a predetermined resist pattern was formed through the development using a TLD developing solution (developing solution manufactured by Think Laboratory Co., Ltd.) at a developing solution dilution ratio between an undiluted solution and water of 1:7 at 24°C for 90 seconds. The predetermined resist pattern to be formed was a stepless gradation pattern in which multiple mesh filter-shaped resist patterns of different openings each falling within a range of from 10 µm to 200 µm was formed so that the openings changed in a stepless manner.

An intermediate layer having a film thickness of 0.1 µm was formed using hexamethyldisiloxane as a raw material gas at a film formation temperature of from 80°C to 120°C for a film formation time period of 60 minutes under an argon/hydrogen gas atmosphere. Next, a DLC layer having a film thickness of 2 µm was formed using toluene as a raw material gas at a film formation temperature of from 80°C to 120°C for a film formation time period of 180 minutes.

Next, the resist was peeled off through use of a 5% sodium hydroxide aqueous solution to form DLC patterns in which a plurality of circular protrusions having different diameters coexisted as illustrated in FIG. 2. The DLC patterns were formed so that the plurality of circular protrusions each having a diameter of from 200 µm to 10 µm coexisted on the base material in a stepless gradational manner. Thus, a roll with DLC patterns was obtained.

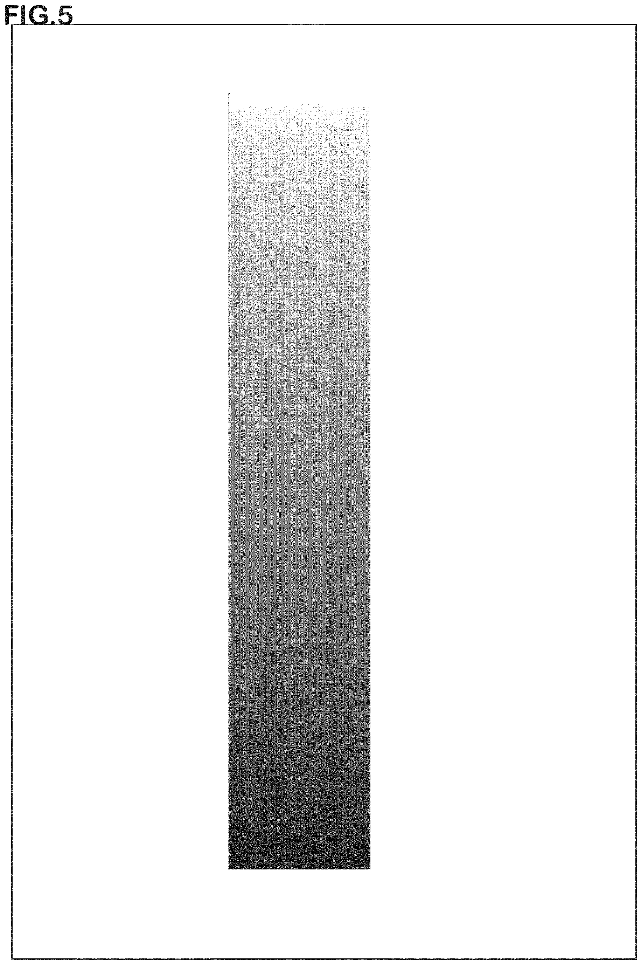

Next, the roll with DLC patterns was mounted to a copper plating bath. The roll with DLC patterns was fully immersed in a plating solution, and a copper pattern foil having a thickness of 20 µm was obtained at 2 A/dm² and 2.0 V. The surface of the copper pattern foil was observed with an optical microscope. As a result, as shown in FIG. 5, a mesh filter including stepless gradational mesh filter zones which were changed, in a stepless manner, from a mesh filter zone having formed therein a plurality of holes each having a diameter of 200 µm (opening: 200 µm) to a mesh filter zone having formed therein a plurality of holes each having a diameter of 10 µm (opening: 10 µm) was obtained.

### Reference Signs List

10: mesh filter, 12, 14, 16: hole, 18a, 18b: slide mechanism, 20: fluid flow rate or light amount control mechanism, 22: roll with DLC pattern, 24: through hole, 26: cylindrical metal base material, 28: DLC pattern, 30, 32, 34: circular protrusion, 36: photoresist, 38: mesh filter-shaped resist pattern, 40: DLC coating film, 42, 44, 46: mesh filter zone.

## Claims

1. A method of producing a mesh filter, comprising steps of:
preparing a cylindrical platable metal base material;
forming a mesh filter-shaped resist pattern by applying a photoresist onto a surface of the cylindrical metal base material, exposure and development;
forming a DLC coating film on surfaces of the cylindrical metal base material and the mesh filter-shaped resist pattern;
forming a DLC pattern on the surface of the cylindrical metal base material by peeling off the DLC coating film formed on the mesh filter-shaped resist pattern together with the mesh filter-shaped resist pattern, thereby producing a roll with the DLC pattern; and
producing a mesh filter by continuous plating of a platable metal using the roll with the DLC pattern,
wherein the mesh filter-shaped resist pattern is obtained by forming multiple mesh filter-shaped resist patterns of different openings on the same cylindrical metal base material.

2. A method of producing a mesh filter according to claim 1, wherein the metal base material, onto which the photoresist is to be applied, is formed of at least one kind of material selected from the group consisting of nickel, tungsten, chromium, titanium, gold, silver, platinum, stainless steel, iron, copper, and aluminum.

3. A method of producing a mesh filter according to claim 1 or 2, wherein the DLC coating film has a thickness of from 0.1 µm to 20 µm.

4. A method of producing a mesh filter according to any one of claims 1 to 3, wherein the multiple mesh filter-shaped resist patterns of different openings are a stepless gradation pattern in which sizes of the openings change in a stepless manner.

5. A mesh filter, which is produced by continuously plating a platable metal using a roll with a DLC pattern,
wherein the roll with the DLC pattern is produced by:
forming a mesh filter-shaped resist pattern by applying a photoresist onto a surface of a cylindrical platable metal base material, exposure and development;
forming a DLC coating film on surfaces of the cylindrical metal base material and the mesh filter-shaped resist pattern; and
forming a DLC pattern on the surface of the cylindrical metal base material by peeling off the DLC coating film formed on the mesh filter-shaped resist pattern together with the mesh filter-shaped resist pattern,
wherein the mesh filter-shaped resist pattern is obtained by forming multiple mesh filter-shaped resist patterns of different openings on the same cylindrical metal base material, and
wherein the mesh filter comprises a plurality of mesh filter zones of different openings.

6. A mesh filter according to claim 5, wherein the metal base material, onto which the photoresist is to be applied, is formed of at least one kind of material selected from the group consisting of nickel, tungsten, chromium, titanium, gold, silver, platinum, stainless steel, iron, copper, and aluminum.

7. A mesh filter according to claim 5 or 6, wherein the DLC coating film has a thickness of from 0.1 µm to 20 µm.

8. A mesh filter according to any one of claims 5 to 7, wherein the multiple mesh filter-shaped resist patterns of different openings are a stepless gradation pattern in which sizes of the openings change in a stepless manner.

9. A fluid flow rate control mechanism, comprising:
the mesh filter of any one of claims 5 to 8 comprising a plurality of mesh filter zones of different openings; and
a slide mechanism configured to slide the mesh filter,
the fluid flow rate control mechanism being capable of controlling a flow rate of a fluid through a mesh filter zone of an arbitrary opening by sliding the mesh filter.

10. A light amount control mechanism, comprising:
the mesh filter of any one of claims 5 to 8 comprising a plurality of mesh filter zones of different openings; and
a slide mechanism configured to slide the mesh filter,
the light amount control mechanism being capable of controlling a light amount through a mesh filter zone of an arbitrary opening by sliding the mesh filter.
